# EUROPÄISCHE PATENTSCHRIFT

(11) **EP 1 080 977 B1**
(45) Veröffentlichungstag und Bekanntmachung des Hinweises auf die Patenterteilung: **11.10.2006**
(21) Anmeldenummer: 00115615.7
(22) Anmeldetag: 20.07.2000
(51) Int. Cl.: B60K 37/02

(54) **Kombiinstrument**
Combined instrument
Combiné indicateur

(30) Priorität: 31.08.1999 DE 19941352
(43) Veröffentlichungstag der Anmeldung: 07.03.2001
(73) Patentinhaber: SIEMENS AKTIENGESELLSCHAFT, 80333 München (DE)
(72) Erfinder: Kronenberg, Hartmut, 26969 Butjadingen (DE); Simon, Ernst-Ulrich, 61440 Oberursel (DE)

(56) Entgegenhaltungen:
- EP-A- 0 478 218
- EP-A- 0 645 276
- WO-A-98/06594
- US-A- 5 003 433
- PATENT ABSTRACTS OF JAPAN vol. 016, no. 446 (M-1311), 17. September 1992 (1992-09-17) -& JP 04 154436 A (HITACHI LTD), 27. Mai 1992 (1992-05-27)
- PATENT ABSTRACTS OF JAPAN vol. 1996, no. 09, 30. September 1996 (1996-09-30) & JP 08 129165 A (NIPPON SEIKI CO LTD), 21. Mai 1996 (1996-05-21)

## Beschreibung

Die Erfindung betrifft ein Kombiinstrument mit einem Grundkörper, welcher in Anzeigefelder aufgeteilt ist, die mit unterschiedlichen Winkeln zueinander ausgerichtet sind und welches auf der Rückseite des Grundkörpers eine starre Hauptleiterplatte aufweist.

Kombiinstrumente der vorstehenden Art sind in heutigen Kraftfahrzeugen vorhanden und deshalb allgemein bekannt. Die US-A-5003 433 beschreibt ein Kombiinstrument mit einem Grundkörper, welcher in Anzeigefelder aufgeteilt ist, wobei das Kombiinstrument auf der Rückseite des Grundkörpers eine starre Hauptleiterplatte aufweist. Auf der Vorderseite des Grundkörpers ist eine sich auf mehrere Anzeigefelder erstreckende zusätzliche Leiterplatte angeordnet.

Die unterschiedliche Ausrichtung der Anzeigefelder dient meist dazu, die Ablesbarkeit der Anzeigen dadurch zu verbessern, dass die Anzeigefelder zum Fahrer hin ausgerichtet sind. Schwierigkeiten bereitet bei solchen Kombiinstrumenten die elektrische Verbindung der einzelnen Messwerke und der elektrischen und elektronischen Bauteile. In der Praxis ordnet man für jedes Anzeigefeld eine separate Leiterplatte an, welche parallel zur jeweiligen Ebene des Anzeigefeldes ausgerichtet ist, damit auf ihr zum Beispiel ein Messwerk in der gewünschten Winkelausrichtung angeordnet werden kann. Die Anordnung mehrerer separater Leiterplatten bedingt einen unerwünscht großen Kostenaufwand.

Der Erfindung liegt das Problem zugrunde, ein Kombiinstrument der eingangs genannten Art so auszubilden, dass es trotz der Anordnung unterschiedlich ausgerichteter Anzeigefelder möglichst kostengünstig herzustellen ist.

Dieses Problem wird erfindungsgemäß durch ein Kombiinstrument mit den Merkmalen des Anspruchs 1 gelöst.

Durch diese Gestaltung kann man eine einzige Leiterplatte für die verschiedenen Anzeigefelder verwenden, indem man diese Leiterplatte in ihren Verbindungsbereichen entsprechend der unterschiedlichen Ausrichtung der Anzeigefelder biegt. Da die Verbindungsbereiche Leiterbahnen aufweisen, brauchen sie nicht nach der Montage der Leiterplatte durch zusätzliche Arbeitsgänge miteinander elektrisch verbunden zu werden. Hinzu kommt, dass die Handhabung nur einer einzigen Leiterplatte für mehrere Anzeigefelder statt separater Leiterplatten für jedes Anzeigefeld eine starke Vereinfachung darstellt.

Besonders kostengünstig sind die flexiblen Verbindungsbereiche zu erzeugen, wenn sie durch eine Verringerung der Dicke der Leiterplatte in den Verbindungsbereichen gebildet sind.

Die zusätzliche Leiterplatte kann ohne separate Befestigungsmittel auf dem Grundkörper gehalten sein, wenn auf der zusätzlichen Leiterplatte auf dem Grundkörper befestigte Messwerke und Lichtkästen montiert sind.

Der Grundkörper kann sich unterschiedlichen räumlichen Gegebenheiten anpassen, wenn gemäß einer anderen Weiterbildung der Erfindung die Anzeigefelder des Grundkörpers durch flexible Verbindungsstücke miteinander verbunden sind.

Eine besonders hohe Biegsamkeit der Verbindungsstücke erreicht man, wenn die Verbindungsstücke quer zur Ebene der Anzeigefelder u-förmig ausgebildet sind.

Die Erfindung lässt verschiedene Ausführungsformen zu. Zur weiteren Verdeutlichung ihres Grundprinzips ist eine davon schematisch in der Zeichnung dargestellt und wird nachfolgend beschrieben. Die Zeichnung zeigt in
- Fig.1: eine Vorderansicht auf eine erfindungsgemäß gestaltete Leiterplatte,
- Fig.2: einen Teilbereich eines Kombiinstrumentes nach der Erfindung,
- Fig.3: eine Draufsicht auf einen Grundkörper des Kombiinstrumentes.

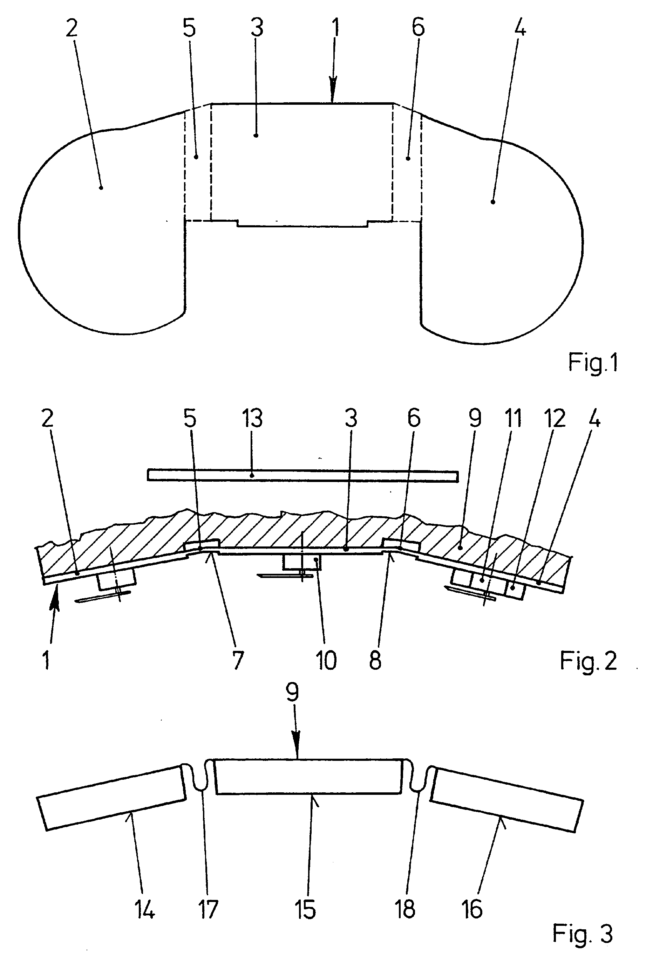

Die Figur 1 zeigt eine Leiterplatte 1, welche aus drei starren Leiterplattenteilen 2, 3, 4 besteht, die durch flexible Verbindungsbereiche 5, 6 miteinander verbunden sind. Diese flexiblen Verbindungsbereiche 5, 6 können, was die Figur 2 erkennen lässt, durch Ausfräsungen 7, 8 gebildet sein, also dadurch, dass die Dicke der Leiterplatte 1 in den Verbindungsbereichen 5, 6 herabgesetzt wurde. Möglich ist es jedoch auch, die Verbindungsbereiche 5, 6 durch u-förmig verlaufende Abschnitte zu bilden, wobei in allen Fällen elektrische Leiterbahnen über die Verbindungsbereiche 5, 6 hinweg verlaufen, damit die Leiterplattenteile 2, 3, 4 elektrisch miteinander verbunden sind.

In Figur 2 ist schraffiert ein Teilbereich eines Grundkörpers 9 dargestellt, gegen dessen Vorderseite die Leiterplatte 1 anliegt. Messwerke 10, 11 oder Lichtkästen 12 sitzen von vorn her auf der Leiterplatte 1 und sind auf dem Grundkörper 9 auf übliche, nicht gezeigte Weise fixiert, so dass die Messwerke 10, 11 und/oder Lichtkästen 12 die Leiterplatte 1 auf dem Grundkörper 9 halten. Hinter der Rückseite des Grundkörpers 9 erkennt man eine starre Hauptleiterplatte 13, welche diejenigen Bauteile trägt, die nicht auf der Leiterplatte 1 zu befestigen sind.

Die Figur 3 zeigt, dass der Grundkörper 9 drei in unterschiedlicher Winkelausrichtung verlaufende Anzeigefelder 14, 15, 16 hat, welche jeweils durch u-förmige Verbindungsstücke 17, 18 flexibel miteinander verbunden sind.

## Patentansprüche

1. Kombiinstrument mit einem Grundkörper (9), welcher in Anzeigefelder (14, 15, 16) aufgeteilt ist, welches auf der Rückseite des Grundkörpers eine starre Hauptleiterplatte (13) aufweist, wobei auf der Vorderseite des Grundkörpers (9) eine sich über mehrere Anzeigefelder erstreckende zusätzliche Leiterplatte (1) angeordnet ist, **dadurch gekennzeichnet, dass** die Anzeigefelder (14, 15, 16) mit unterschiedlichen Winkeln zueinander ausgerichtet sind und die zusätzliche Leiterplatte (1) aus starren Leiterplattenteilen (2, 3, 4) besteht, welche im Übergangsbereich der Anzeigefelder flexible Verbindungsbereiche mit Leiterbahnen aufweisen, dass die flexiblen Verbindungsbereiche (5, 6) durch eine Verringerung der Dicke der Leiterplatte (1) in den Verbindungsbereichen (5, 6) gebildet sind.

2. Kombiinstrument nach zumindest einem der vorangehenden Ansprüche, **dadurch gekennzeichnet, dass** auf der zusätzlichen Leiterplatte (1) auf dem Grundkörper (9) befestigte Messwerke (10, 11) und Lichtkästen (12) montiert sind.

3. Kombiinstrument nach zumindest einem der vorangehenden Ansprüche, **dadurch gekennzeichnet, dass** die Anzeigefelder (14, 15, 16) des Grundkörpers (9) durch flexible Verbindungsstücke (17, 18) miteinander verbunden sind.

4. Kombiinstrument nach Anspruch 3, **dadurch gekennzeichnet, dass** die Verbindungsstücke (17, 18) quer zur Ebene der Anzeigefelder (14, 15, 16) u-förmig ausgebildet sind.

## Claims

1. Combination instrument having a base body (9) which is split into display areas (14, 15, 16) and which has a rigid main printed circuit (13) on the back of the base body, an additional printed circuit (1) extending over a plurality of display areas being arranged on the front of the base body (9), **characterized in that** the display areas (14, 15, 16) are oriented at different angles relative to one another, and the additional printed circuit (1) comprises rigid printed circuit parts (2, 3, 4) which have flexible connecting regions with conductor tracks in the junction region of the display areas, and **in that** the flexible connecting regions (5, 6) are formed by a reduction in the thickness of the printed circuit (1) in the connecting regions (5, 6).

2. Combination instrument according to Claim 1, **characterized in that** instruments (10, 11) and light boxes (12) attached to the base body (9) are mounted on the additional printed circuit (1).

3. Combination instrument according to at least one of the preceding claims, **characterized in that** the display areas (14, 15, 16) on the base body (9) are connected to one another by flexible connecting pieces (17, 18).

4. Combination instrument according to Claim 3, **characterized in that** the connecting pieces (17, 18) are of u-shaped design transversely with respect to the plane of the display areas (14, 15, 16).

## Revendications

1. Indicateur combiné ayant un corps de base (9), qui est partagé en champs d'affichage (14, 15, 16) et qui comporte, sur la face arrière du corps de base, une carte principale à circuits imprimés rigide (13), une carte à circuits imprimés supplémentaire (1) s'étendant sur plusieurs champs d'affichage étant disposée sur la face avant du corps de base (9), **caractérisé par le fait que** les champs d'affichage (14, 15, 16) sont orientés l'un par rapport à l'autre sous différents angles et que la carte à circuits imprimés supplémentaire (1) se compose de parties rigides (2, 3, 4) de cartes à circuits imprimés, lesquelles comportent, dans la zones de transition entre les champs d'affichage, des zones de raccordement souples avec des pistes conductibles, et que les zones de raccordement souples (5, 6) sont formées par une diminution de l'épaisseur de la carte à circuits imprimés (1) dans les zones de raccordement (5, 6).

2. Indicateur combiné selon au moins l'une des revendications précédentes, **caractérisé par le fait que** des équipages de mesure (10, 11) et des boîtes à lumière (12) fixés sur le corps de base (9) sont montés sur la carte à circuits imprimés supplémentaire (1).

3. Indicateur combiné selon au moins l'une des revendications précédentes, **caractérisé par le fait que** les champs d'affichage (14, 15, 16) du corps de base (9) sont reliés les uns aux autres par des pièces de raccordement souples (17, 18).

4. Indicateur combiné selon la revendication 3, **caractérisé par le fait que** les pièces de raccordement souples (17, 18) sont conçues en forme de U perpendiculairement au plan des champs d'affichage (14, 15, 16).
